# EUROPEAN PATENT APPLICATION

(11) **EP 4 326 016 A1**
(43) Date of publication of application: **21.02.2024**
(21) Application number: 22788350.1
(22) Date of filing: 08.04.2022
(51) Int. Cl.: H05K 5/00

(54) **ELECTRIC/ELECTRONIC EQUIPMENT AND METHOD FOR MANUFACTURING SAME**

(30) Priority: 13.04.2021 KR 20210047961; 27.01.2022 KR 20220012703
(71) Applicant: LG Innotek Co., Ltd., Seoul 07796 (KR)
(72) Inventor: KIM, Min Oak, Seoul 07796 (KR); SHIN, Min Jung, Seoul 07796 (KR); LEE, Woo Seok, Seoul 07796 (KR); YOON, Ki Eun, Seoul 07796 (KR)
(74) Representative: DREISS Patentanwälte PartG mbB
(86) International application number: PCT/KR2022/005092
(87) International publication number: WO 2022/220494

(57) **Abstract**

Electric equipment comprises: a housing; a printed circuit board disposed in the housing and including a first hole; and a cover coupled to the upper surface of the housing and including a second hole, wherein the housing comprises: a first region arranged to pass through the first hole; a second region disposed above the first region and arranged to pass through the second hole; and a third region disposed above the second region and placed on the upper surface of the cover.

## Description

### [Technical Field]

The present embodiment relates to An electric equipment and a method for manufacturing same

### [Background Art]

The outer shape of An electric equipment being provided in a vehicle is formed by a housing, and a plurality of electronic components can be disposed inside the housing.

For an example, An electric equipment may include a housing including an inner space, an electronic component being disposed inside the housing, and a cover being coupled to the housing to cover the inner space.

According to the structure as described above, a plurality of fastening structures are required for coupling the housing and the cover and fixing electronic components inside the housing, but there is a problem in that manufacturing cost increases due to an increase in the number of components.

### [Detailed Description of the Invention]

### [Technical Subject]

The present embodiment is to provide An electric equipment and a method for manufacturing same capable of reducing manufacturing cost by reducing the number of components for fastening between multiple configurations and enhancing production efficiency by reducing assembly man-hours.

### [Technical Solution]

An electric equipment according to the present embodiment comprises: a housing; a printed circuit board being disposed inside the housing and including a first hole; and a cover being coupled to an upper surface of the housing and including a second hole, wherein the housing includes: a first region being disposed to penetrate through the first hole; a second region being disposed at an upper portion of the first region and being disposed to penetrate through the second hole; and a third region being disposed at an upper portion of the second region and being disposed on an upper surface of the cover.

The cover is more recessed downwardly from an upper surface than the other regions and may include a coupling groove being disposed with the third region inside thereof.

A lower surface of the third region may be in contact with a bottom surface of the coupling groove.

A lower surface of the housing includes a protruded portion being protruded downward, and a lower surface of the protruded portion may be in contact with an upper surface of the printed circuit board.

An accommodating groove being recessed more upward than other regions may be disposed on a lower surface of the protruded portion, and an upper surface of the first region may be in contact with a bottom surface of the accommodating groove.

The cross-sectional area of the first region may be larger than the cross-sectional area of the second region.

A groove being formed along an edge of the second region may be disposed on an upper surface of the first region.

In a method for manufacturing An electric equipment according to the present embodiment comprising: a housing including a first coupling portion being protruded upward from an upper surface; a printed circuit board being disposed at an upper portion of the housing and including a first hole; and a cover comprising a second coupling portion being disposed at an upper portion of the printed circuit board, having a coupling groove being formed on an upper surface, and being protruded upward from a bottom surface of the coupling groove, and a second hole penetrating a lower surface from the bottom surface of the coupling groove, the method comprises the steps of: (a) penetrating through the first hole and the second hole by the first coupling portion; and (b) forming a protrusion inside the coupling groove by fusing the first coupling portion or the second coupling portion with heat or laser.

The height of the first coupling portion being protruded from the bottom surface of the coupling groove may be the same as the height of the second coupling portion being protruded from the bottom surface of the coupling groove.

The height of the first coupling portion being protruded from a bottom surface of the coupling groove may be greater than the height of the second coupling portion being protruded from a bottom surface of the coupling groove.

### [Advantageous Effects]

Since the housing, the cover, and the printed circuit board are coupled to each other through a single protrusion through the present embodiment, there is an advantage in that the number of components is reduced and the fastening process can be performed more simply.

### [Brief Description of Drawings]

FIG. 1 is an exploded perspective view of An electric equipment according to a first embodiment of the present invention.
FIG. 2 is a cross-sectional view illustrating a coupling structure of a housing, a cover and a printed circuit board according to a first embodiment of the present invention.
FIG. 3 is a perspective view illustrating a part of an upper surface of the cover according to a first embodiment of the present invention.
FIG. 4 is a perspective view of a first coupling portion according to a first embodiment of the present invention.
FIG. 5 is a perspective view illustrating a coupling groove of a cover according to a first embodiment of the present invention.
FIG. 6 is a cross-sectional view illustrating a coupling structure of a housing, a cover, and a printed circuit board in An electric equipment before fusion according to a first embodiment of the present invention.
FIG. 7 is a cross-sectional view comparing deformations of a first coupling portion and a second coupling portion before and after fusion according to a first embodiment of the present invention.
FIG. 8 is a view for explaining the fusion process according to a first embodiment of the present invention.
FIG. 9 is a view illustrating a modified embodiment of a first coupling portion and a second coupling portion according to a first embodiment of the present invention.
FIG. 10 is a cross-sectional view illustrating a coupling structure of a housing, a cover, and a printed circuit board through fused protrusions according to the shape of FIG. 9.
FIG. 11 is a view illustrating another modified embodiment of a first coupling portion and a second coupling portion according to a first embodiment of the present invention.
FIG. 12 is a perspective view illustrating an outer appearance of An electric equipment according to a second embodiment of the present invention.
FIG. 13 is a cross-sectional view of An electric equipment according to a second embodiment of the present invention.
FIG. 14 is an exploded perspective view of An electric equipment according to a second embodiment of the present invention.
FIG. 15 is a diagram illustrating FIG. 14 from another angle.
FIG. 16 is a view illustrating an assembly process of a housing, a cover and a printed circuit board according to a second embodiment of the present invention.
FIGS. 17 to 20 are views sequentially illustrating a process of assembling a housing, a cover, and a printed circuit board according to a second embodiment of the present invention.
FIG. 21 is a cross-sectional view illustrating a coupling structure of a housing, a cover, and a printed circuit board inside An electric equipment before a fusion process according to a second embodiment of the present invention.
FIG. 22 is a view showing a coupling structure of a housing, a cover, and a printed circuit board after a fusion process according to a second embodiment of the present invention.

### [BEST MODE]

Hereinafter, preferred embodiments of the present invention will be described in detail with reference to the accompanying drawings.

However, the technical idea of the present invention is not limited to some of the described embodiments and can be implemented in various different forms, and within the scope of the technical idea of the present invention, one or more of the components may be selectively combined or substituted and used between embodiments.

In addition, the terms (including technical and scientific terms) used in the embodiments of the present invention, unless explicitly defined and described, can be interpreted as a meaning that can be generally understood by a person skilled in the art, and commonly used terms such as terms defined in the dictionary may be interpreted in consideration of the meaning of the context of the related technology.

In addition, terms used in the present specification are for describing embodiments and are not intended to limit the present invention. In the present specification, the singular form may include the plural form unless specifically stated in the phrase, and when described as "at least one (or more than one) of A and B and C", it may include one or more of all combinations that can be combined with A, B, and C.

In addition, in describing the components of the embodiment of the present invention, terms such as first, second, A, B, (a), and (b) may be used. These terms are merely intended to distinguish the components from other components, and the terms do not limit the nature, order or sequence of the components.

And, when a component is described as being 'connected', 'coupled' or 'interconnected' to another component, the component is not only directly connected, coupled or interconnected to the other component, but may also include cases of being 'connected', 'coupled', or 'interconnected' due that another component between that other components.

In addition, when described as being formed or arranged in "on (above)" or "below (under)" of each component, "on (above)" or "below (under)" means that it includes not only the case where the two components are directly in contact with, but also the case where one or more other components are formed or arranged between the two components. In addition, when expressed as "on (above)" or "below (under)", the meaning of not only an upward direction but also a downward direction based on one component may be included.

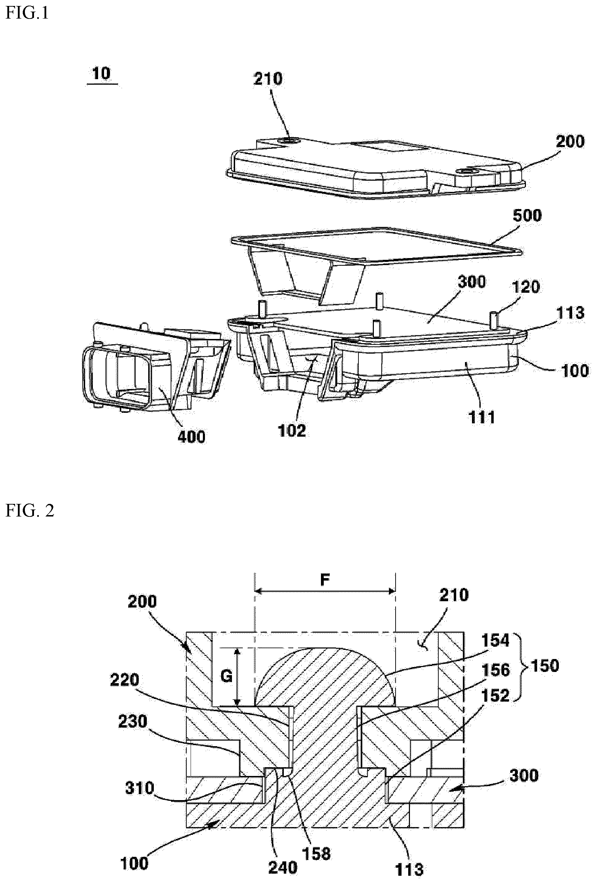

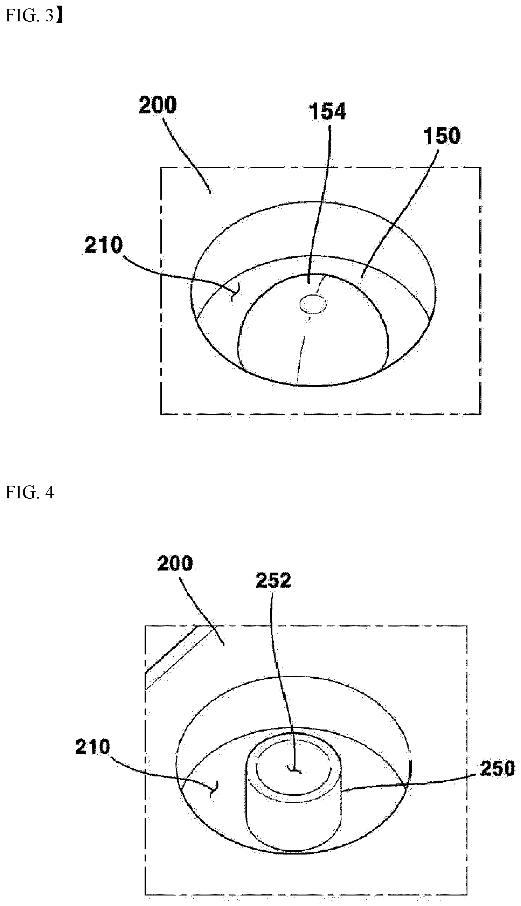

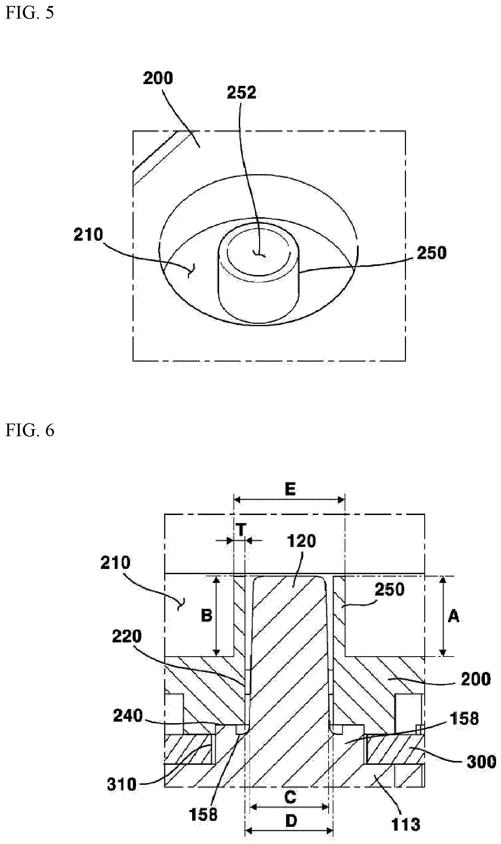

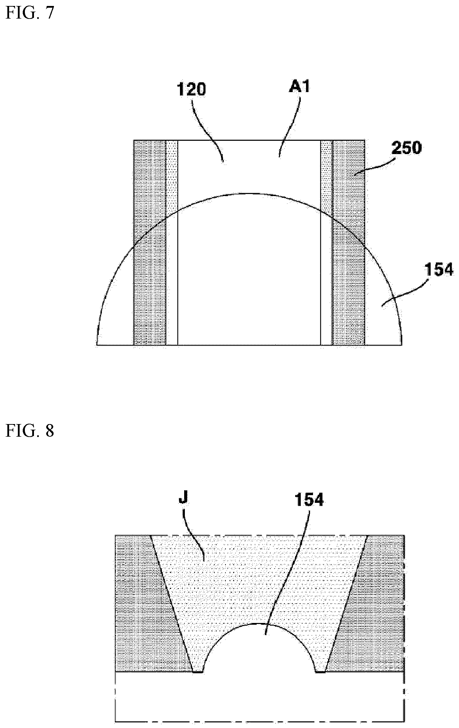

FIG. 1 is an exploded perspective view of An electric equipment according to a first embodiment of the present invention; FIG. 2 is a cross-sectional view illustrating a coupling structure of a housing, a cover and a printed circuit board according to a first embodiment of the present invention; FIG. 3 is a perspective view illustrating a part of an upper surface of the cover according to a first embodiment of the present invention; FIG. 4 is a perspective view of a first coupling portion according to a first embodiment of the present invention; FIG. 5 is a perspective view illustrating a coupling groove of a cover according to a first embodiment of the present invention; FIG. 6 is a cross-sectional view illustrating a coupling structure of a housing, a cover, and a printed circuit board in An electric equipment before fusion according to a first embodiment of the present invention; FIG. 7 is a cross-sectional view comparing deformations of a first coupling portion and a second coupling portion before and after fusion according to a first embodiment of the present invention; and FIG. 8 is a view for explaining the fusion process according to a first embodiment of the present invention.

FIGS. 1, 4, 5, and 6 are views illustrating a coupled state of An electric equipment before thermal fusion, and FIGS. 2 and 3 are views illustrating a coupled state of An electric equipment after thermal fusion.

Referring to FIGS. 1 to 8, An electric equipment **10** according to a first embodiment of the present invention may have an external shape by coupling the housing **100** and the cover **200.**

The housing **100** is formed with a space for accommodating at least one or more components therein, and may have a rectangular cross-sectional shape. The housing **100** may include: a side surface portion **111** forming a side surface, an upper surface portion **113** being bent inwardly at an upper end of the side surface portion **111,** and a lower surface portion being bent inwardly at a lower end of the side surface portion **111.** An upper surface of the lower portion may form a bottom surface of the space. The upper surface portion **113** may be disposed at an upper edge region of the housing **100** to which the cover **200** is coupled.

A connector **400** being coupled with a terminal (not shown) for connecting The electric equipment **10** and other configurations may be disposed on a side surface of the housing **100.** A hole-shaped connector coupling portion **102** penetrating an inner surface from an outer surface so as to be coupled to the connector **400** may be disposed on the side surface portion **111.**

The housing **100** may be formed of a plastic material.

The cover **200** may be coupled to an upper surface of the housing **100.** Through the coupling of the cover **200,** the space inside the housing **100** may be covered from an external region. The cross section of the cover **100** may be formed to correspond to the cross sectional shape of the housing **100.** The cover **100** may be formed of a plastic material.

At least one electronic component for driving The electric equipment **10** may be disposed in a space inside the housing **100.** The electronic component may include the printed circuit board **300.** The printed circuit board **300** is formed in a plate shape and may be coupled to an upper surface of the housing **100.** The printed circuit board **300** may be disposed on an upper surface of the upper surface portion **113.** In this case, an upper surface of the upper surface portion **113** may be disposed downward to have a step lower than an upper surface of the side surface portion **111** by a predetermined distance. At least one or more elements for driving may be mounted on the printed circuit board **300.**

Between the housing **100** and the cover **200** and between the housing **100** and the connector **400,** a sealing member **500** may be disposed to prevent external foreign substances from entering the space inside the housing **100.** The sealing member **500** is formed of a rubber material, and may be disposed to seal the regions between the housing **100** and the cover **200** and between the housing **100** and the connector **400.**

Hereinafter, a coupling structure of the housing **100,** the cover **200** and the printed circuit board **300** will be described.

Referring to FIG. 2, the housing **100,** the cover **200** and the printed circuit board **300** may be coupled to each other through a protrusion **150.** The protrusion **150** is protruded upward from an upper surface of the upper surface portion **113** of the housing **100** and may be disposed to penetrate through the printed circuit board **300** and the cover **200.**

In detail, the protrusion **150** protrudes upward from an upper surface of the upper surface portion **113** of the housing **100** and may include a first region **152,** a second region **156,** and a third region **154.**

The first region **152** is protruded upward from an upper surface of the upper surface portion **113** and may be disposed to penetrate through the printed circuit board **300.** A first hole **310** may be formed in the printed circuit board **300** so that the first region **152** penetrates therethrough. A cross-sectional shape of the first hole **310** may be formed to correspond to a cross-sectional shape of the first region **152.** The first hole **310** and the first region **152** may have a first cross-sectional area. The cross-sectional area of the first region **152** may be smaller than the cross-sectional area of the first hole **310** so that the outer circumferential surface of the first region **152** may be spaced apart from the inner circumferential surface of the first hole **310** by a predetermined distance. The thickness of the first region **152** in a vertical direction may correspond to or be greater than the thickness of the printed circuit board **300** in a vertical direction. An upper surface of the first region **152** may come into contact with a bottom surface of an accommodating groove **240** in a protruded portion **230** of the cover **200,** which will be described later.

The second region **156** may be disposed to connect the first region **152** and the third region **154.** The second region **156** may be disposed to penetrate through the cover **200.** The cover **200** may include a second hole **220** penetrating through a lower surface from an upper surface and having the second region **156** disposed therein. The cross-sectional shape of the second hole **220** may be formed to correspond to the cross-sectional shape of the second region **156.** The second region **156** and the second hole **220** may have a second cross-sectional area. The second cross-sectional area may be smaller than the first cross-sectional area. Unlike this, the cross-sectional area of the second region **156** is smaller than the cross-sectional area of the second hole **220,** and of course, an outer circumferential surface of the second region **156** may be spaced apart from an inner circumferential surface of the second hole **220** by a predetermined distance.

A groove **158** being concavely recessed downward than other regions may be formed in a lower edge region of the second region **156** of the upper surface of the first region **152.** Accordingly, the other upper region of the first region **152** is in contact with a bottom surface of the receiving groove **240,** and a bottom surface of the groove **158** may be spaced apart from a bottom surface of the accommodating groove **240** by a predetermined distance. Assembly tolerances can be secured through the grooves **158,** and foreign substances including molten material can be prevented from being accommodated in the grooves **158** and flowing into other regions in a fusion process, which will to be described later.

A third region **154** may be disposed at an upper portion of the second region **156.** The third region **154** may have a dome shape. The third region **154** may be formed in a hemispherical shape. The third region **154** may be disposed on an upper surface of the cover **200.** An upper surface of the cover **200** may be recessed downward than other regions, and a coupling groove **210** in which the third region **154** is disposed may be formed therein. A lower surface of the third region **154** is in contact with a bottom surface of the coupling groove **210,** and may be a structure in which the second region **156** being extended downward from the third region **154** is disposed inside the second hole **220.** An upper surface of the third region **154** may be a curved surface. An upper surface of the third region **154** may be disposed lower than an upper surface of the cover **200.**

The third region **154** may be a region in which the first coupling portion **120** of the housing **100,** which will be described later, and the second coupling portion **250** of the cover **200** are fused by heat or laser.

The diameter **F** of the third region **154** may be 4 mm to 6 mm, and the height **G** from the bottom surface of the coupling groove **210** to an upper end of the third region **154** may be 2 mm to 4 mm. A side surface of the third region **154** may be spaced apart from an inner circumferential surface of the coupling groove **210.**

The cover **200** may include: a protruded portion **230** being protruded downward from a lower surface facing the space inside the housing **100;** and a second hole **220** penetrating the bottom surface of the coupling groove **210** from the lower surface of the protruded portion **230.**

The protruded portion **230** is protruded more downward from a lower surface of the cover **200** than other regions, and a lower surface may come into contact with an upper surface of the printed circuit board **300.** The accommodating groove **240** may be disposed in the center of a lower surface of the protruded portion **230** in a shape that is more recessed than other regions, and the accommodating groove **240** is formed to have a cross section corresponding to the cross sectional shape of the first region **152** and can accommodate a portion of an upper end of the first region **152.** An upper surface of the first region **152** may be in contact with a bottom surface of the accommodating groove **240.**

The coupling groove **210** is disposed on an upper surface of the cover **200** so that the second hole **220** may be formed to penetrate through a bottom surface of the accommodating groove **240** from a bottom surface of the coupling groove **210.**

The protrusion **150** is provided in plural and may be disposed to be spaced apart along the edges of the housing **100** and the cover **200.**

According to the structure as described above, since the housing, the cover and the printed circuit board are coupled to each other through a single protrusion, there are advantages in that the number of components is reduced and the fastening process can be performed more simply.

Meanwhile, as described above, the protrusion **150** may be a region in which at least a portion of the cover **200** or the housing **100** is fused by heat or laser. Hereinafter, a method of coupling the housing **100,** the printed circuit board **300,** and the cover **200** will be described.

First, as shown in FIG. 6, a first coupling portion **120** being protruded upward may be disposed on an upper surface of the housing **100** before fusing. The first coupling portion **120** may be disposed to be protruded upward from an upper surface of the upper surface portion **113.** The first coupling portion **120** may be disposed to be protruded upward from a bottom surface of the coupling groove **210** through the second hole **220.**

And, as shown in FIGS. 5 and 6, a second coupling portion **250** may be disposed inside the coupling groove **210.** The second coupling portion **250** may have a shape being protruded upward from a bottom surface of the coupling groove **210.** A hole **252** (see FIG. 5) may be formed inside the second coupling portion **250** so that the first coupling portion **120** is disposed.

The protrusion height **B** of the first coupling portion **120** from a bottom surface of the coupling groove **210** may be formed to be corresponding to or larger than the protruding height **A** of the second coupling portion **250** from a bottom surface of the coupling groove **210.** For example, the protruding height **A** of the second coupling portion **250** from a bottom surface of the coupling groove **210** and the protruding height **B** of the first coupling portion **120** from a bottom surface of the coupling groove **210** may be formed to be 2mm to 3mm, respectively.

Also, the diameter **C** of the first coupling portion **120** may be 3 mm to 4 mm, and the thickness (**E**-**D**)/2 of the second coupling portion **250** may be 0.5 mm to 1 mm. In addition, the diameter of the hole **252** being disposed inside the second coupling portion **250** is larger than the diameter of the first coupling portion **120** so that an outer circumferential surface of the first coupling portion **120** and an inner circumferential surface of the second coupling portion **250** can be spaced apart by a predetermined distance.

Therefore, in a state in which the first coupling portion **120** is disposed to penetrate through the first hole **310** of the printed circuit board **300** and the second hole **220** of the cover **200,** when a portion of an upper end of the first coupling portion **120** and a portion of an upper end of the second coupling portion **250** are heated through the fusion jig **J** as shown in FIG. 8, a third region **154** of the protrusion **150** described above may be formed. At this time, when the housing **100** and the cover **200** are made of the same material, due to the material characteristics, the protrusion **150** and the cover **200** can be firmly coupled to each other with a high fusion rate of the first coupling portion 120 and the second coupling portion **250,** and forming of a gap is prevented from being formed between the cover **200** and the protrusion **150** so there is an advantage in that the space inside the housing **100** can be firmly sealed.

Meanwhile, as shown in FIG. 7, the height of the third region **154** is formed lower than the heights of the first coupling portion **120** and the second coupling portion **250** before fusion, and the cross-sectional area of the third region **154** may be larger than the cross-sectional areas of the first coupling portion **120** and the second coupling portion **250** before fusion.

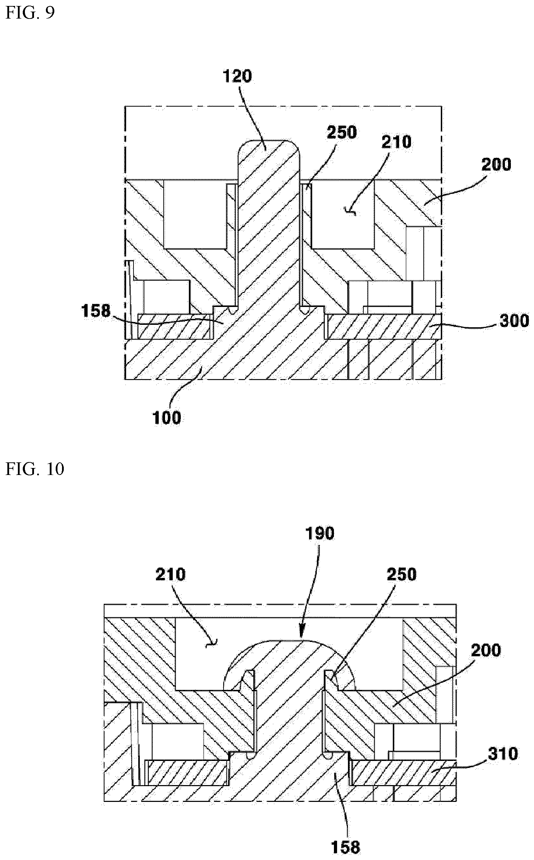

FIG. 9 is a view illustrating a modified embodiment of a first coupling portion and a second coupling portion according to a first embodiment of the present invention; and FIG. 10 is a cross-sectional view illustrating a coupling structure of a housing, a cover, and a printed circuit board through fused protrusions according to the shape of FIG. 9.

Referring to FIGS. 9 and 10, in a modified embodiment, the protruding height of the first coupling portion **120** from a bottom surface of the coupling groove **210** may be greater than the protruding height of the second coupling portion **250** from a bottom surface of the coupling groove **210.** In some cases, the first coupling portion **120** may be disposed further above than an upper surface of the cover **200.**

In this case, since the fusion region is relatively more formed in the first coupling portion **120** than in the second coupling portion **250,** as shown in FIG. 10, an upper region of the protrusion **190** may be formed in a shape in which the fusion region of the first coupling portion **120** surrounds a portion of the second coupling portion **250.**

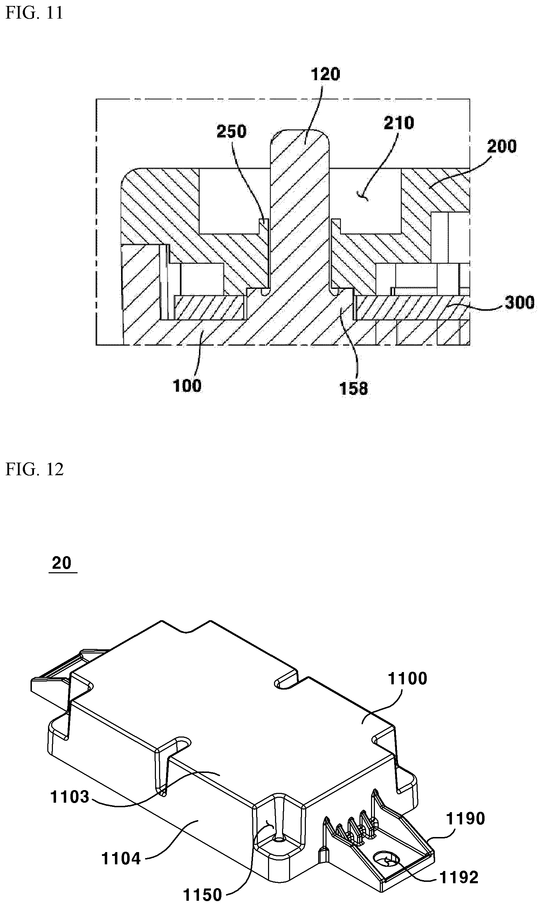

FIG. 11 is a view illustrating another modified embodiment of a first coupling portion and a second coupling portion according to a first embodiment of the present invention.

Referring to FIG. 11, in a modified embodiment, the protruding height of the first coupling portion **120** from a bottom surface of the coupling groove **210** may be formed to be larger than the protruding height of the second coupling portion **250** from a bottom surface of the coupling groove **210.** Unlike the previous modified embodiment, in the modified embodiment, the protruding height of the second coupling portion **250** from a bottom surface of the coupling groove **210** may be formed to be smaller than 1/2 of the protruding height of the first coupling portion **120** from a bottom surface of the coupling groove **210.** In this case, most of the fusion region is formed in the first coupling portion **120,** and an upper end of the protrusion may be formed in a shape in which the fusion region of the first coupling portion **120** surrounds the outer surface of the second coupling portion **250.**

In a modified embodiment, the coupling force is somewhat weaker, but it is characterized in that the fusion process can be performed more conveniently.

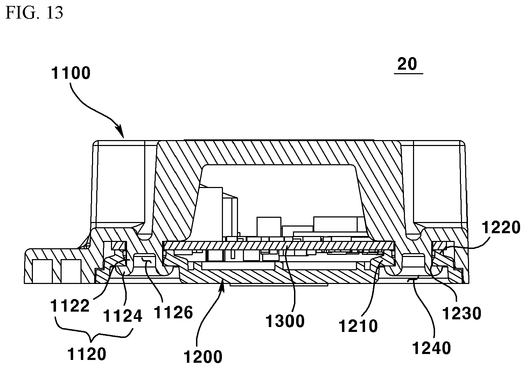

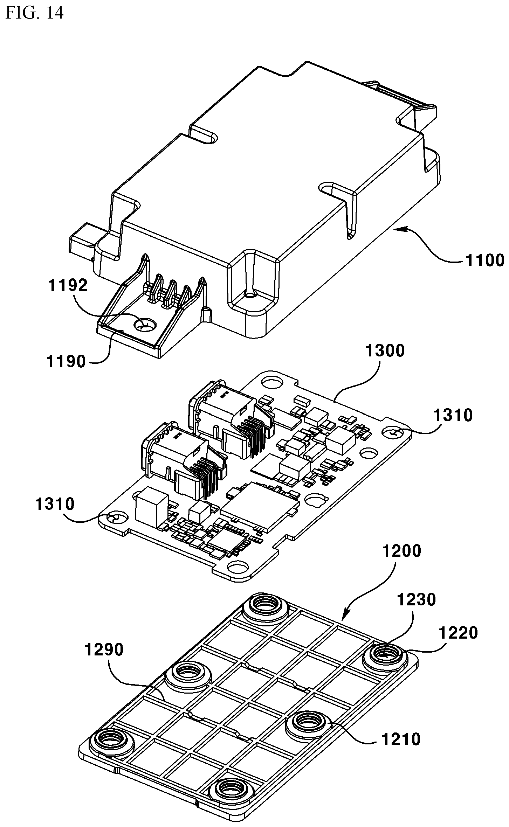

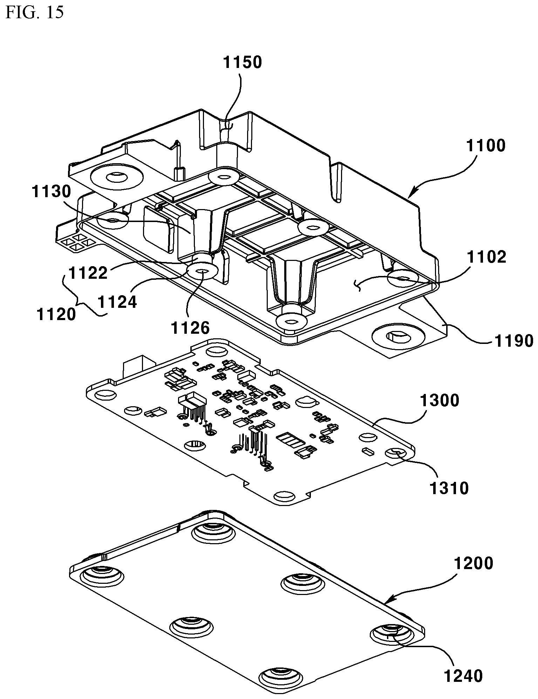

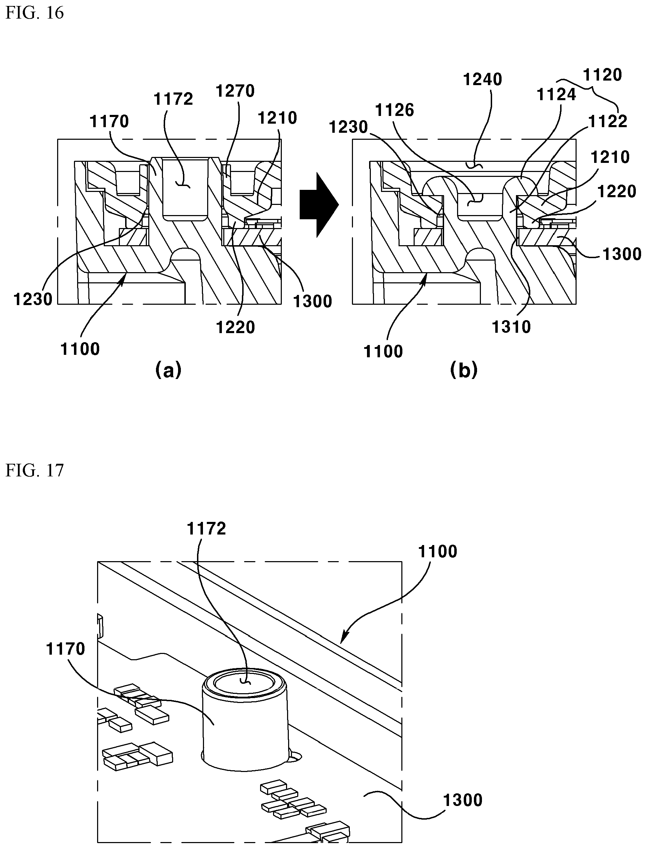

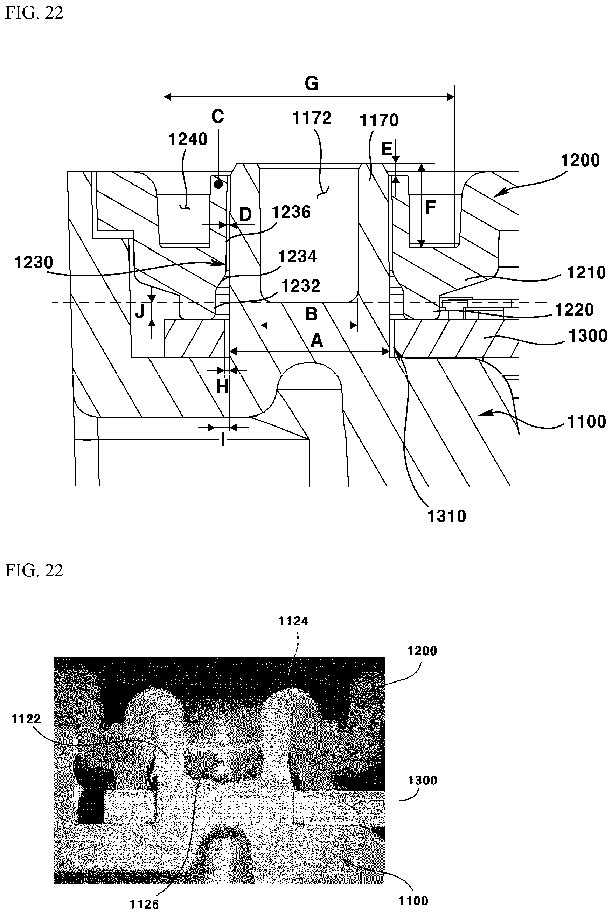

FIG. 12 is a perspective view illustrating an outer appearance of An electric equipment according to a second embodiment of the present invention; FIG. 13 is a cross-sectional view of An electric equipment according to a second embodiment of the present invention; FIG. 14 is an exploded perspective view of An electric equipment according to a second embodiment of the present invention; FIG. 15 is a diagram illustrating FIG. 14 from another angle; FIG. 16 is a view illustrating an assembly process of a housing, a cover and a printed circuit board according to a second embodiment of the present invention; FIGS. 17 to 20 are views sequentially illustrating a process of assembling a housing, a cover, and a printed circuit board according to a second embodiment of the present invention; FIG. 21 is a cross-sectional view illustrating a coupling structure of a housing, a cover, and a printed circuit board inside An electric equipment before a fusion process according to a second embodiment of the present invention; and FIG. 22 is a view showing a coupling structure of a housing, a cover, and a printed circuit board after a fusion process according to a second embodiment of the present invention.

Referring to FIGS. 12 to 22, an external shape of An electric equipment **20** according to a second embodiment of the present invention may be formed by coupling the housing **1100** and the cover **1200.**

The housing **1100** is formed with a space **1102** for accommodating at least one or more components therein, and may have a rectangular cross-sectional shape. The housing **1100** may include a side surface portion **1104** forming a side surface and an upper surface portion **1103** being bent inwardly from an upper end of the side surface portion **1104** to form an upper surface.

The housing **1100** may include one or more coupling portions **1190.** The coupling portion **1190** may have a shape being protruded outwardly from an outer surface of the side surface portion **1104.** The coupling portion **1190** may include a coupling hole **1192** penetrating a lower surface from an upper surface. A screw may penetrate through the coupling hole **1192,** and thus The electric equipment **20** may be coupled to the installation region.

The housing **1100** may be formed of a plastic material.

The cover **1200** may be disposed at a lower portion of the housing **1100.** The cover **1200** may be coupled to a lower surface of the housing **1100.** In this embodiment, it is exemplified that the cover **1200** is disposed at a lower portion of the housing **1100,** but it is not limited thereto, and the housing **1100** is disposed at a lower portion, and the cover **1200** may be disposed at an upper portion of the housing **1100.** By coupling of the cover **1200,** a space **1102** inside the housing **1100** can be covered from the outer region. The cover **1200** may have a cross section corresponding to the cross sectional shape of the housing **1100.** The cover **1200** may be formed of a plastic material.

A sealing member (not shown) may be disposed between the housing **1100** and the cover **1200** to prevent external foreign substances from entering the space inside the housing **1100.** The sealing member is formed of a rubber material and can seal between the housing **1100** and the cover **1200.**

At least one electronic component for driving The electric equipment **20** may be disposed in a space inside the housing **1100.** The electronic component may include the printed circuit board **1300.** The printed circuit board **1300** is formed in a plate shape and may be coupled to an upper surface of the housing **1100.** The printed circuit board **1300** may be disposed between the housing **1100** and the cover **1200.** The upper surface of the printed circuit board **1300** may be spaced apart from the lower surface of the upper surface portion **1103** of the housing **1100** by a predetermined distance. At least one or more elements for driving The electric equipment **20** may be mounted on the printed circuit board **1300.**

Hereinafter, a coupling structure of the housing **1100,** the cover **1200,** and the printed circuit board **1300** will be described.

The housing **1100** may include a first protruded portion **1130.** The first protruded portion **1130** may be protruded downwardly from a lower surface of the upper surface portion **1103.** The first protruded portion **1130** is provided in plurality, and the plurality of first protruded portions **1130** may be spaced apart from one another. For example, some of the plurality of first protruded portions **1130** are respectively disposed in corner regions of the housing **1100,** and other portion may be disposed between one corner of the housing **1100** and another corner adjacent to the one corner. In a region corresponding to the region being formed with the first protruded portion **1130** among the upper surface of the housing **1100,** a groove **1150** in a shape being recessed more downward than other regions may be formed.

A lower surface of the first protruded portion **1130** may be in contact with an upper surface of the printed circuit board **1300.**

The cover **1200** may include a second protruded portion **1210** being protruded upward from an upper surface facing the housing **1100.** The second protruded portion **1210** may have a shape being protruded more upwardly from an upper surface of the cover **1200** than other regions. The second protruded portion **1210** is provided in plurality, and the plurality of second protruded portions **1210** may be spaced apart from one another. The plurality of second protruded portions **1210** may be disposed to be overlapped with the plurality of first protruded portions **1130** in an up and down direction. The second protruded portion **1210** may have a circular cross-sectional shape.

A third protruded portion **1220** being protruded more upwardly than other regions may be formed on an upper surface of the second protruded portion **1210.** An upper surface of the third protruded portion **1220** may be in contact with a lower surface of the printed circuit board **1300.** The third protruded portion **1220** may have a ring-shaped cross-section. Therefore, the printed circuit board **1300** can be firmly fixed inside the space **1102** by the lower surface of the first protruded portion **1130** and the upper surface of the third protruded portion **1220.**

In a lower surface of the cover **1200,** in a region corresponding to a region in which the second protruded portion **1210** is formed, a first groove **1240** in a shape being recessed more upwardly than other regions may be formed. The bottom surface of the first groove **1240** may be disposed to have a step more upwardly than the lower surface of the cover **1200.**

The cover **1200** may include a first hole **1230.** The first hole **1230** may be formed to penetrate through a lower surface of the cover **1200** from an upper surface. The first hole **1230** may be formed inside the second protruded portion **1210.** The first hole **1230** may have a shape penetrating through a bottom surface of the first groove **1240** from an upper surface of the second protruded portion **1210.** The cross-sectional area of the first hole **1230** may be smaller than the cross-sectional area of the first groove **1240.**

The first hole **1230** may include two or more regions having different cross-sectional areas. For example, as illustrated in FIG. 21, the first hole **1230** may include: a first-first hole **1232** having a first diameter; and a first-second hole **1234** having a second diameter smaller than the first diameter. The first-first hole **1232** and the first-second hole **1234** are disposed in an up and down direction and may communicate with each other. The first-second hole **1234** may be disposed below the first-first hole **1232.**

An inclined surface **1236** having a shape in which the cross-sectional area decreases as it travels toward a lower direction may be formed between the first-first hole **1232** and the first-second hole **1234** among an inner surface of the first hole **1230.**

The printed circuit board **1300** may include a second hole **1310.** The second hole **1310** may be formed to penetrate from an upper surface to a lower surface of the printed circuit board **1300.** The second hole **1310** may be formed to have a cross-sectional area smaller than that of the first hole **1230,** but is not limited thereto. For example, the diameter of the second hole **1310** is smaller than the diameter of the first-first hole **1232,** and may be greater than or equal to the diameter of the first-second hole **1234.** The second hole **1310** may be disposed to face the first hole **1230** in an up and down direction.

The housing **1100** may include a protrusion **1120.** The protrusion **1120** may have a shape being protruded downward from a lower surface of the first protruded portion **1130.** The protrusion **1120** may be disposed to penetrate through the second hole **1310** of the printed circuit board **1300** and the first hole **1230** of the cover **1200.**

In detail, the protrusion **1120** may include a first region **1122** being protruded downward from a lower surface of the first protruded portion **1130** and a second region **1124** being disposed at a lower end of the first region **1122.** The first region **1122** may be disposed inside the first hole **1230** and the second hole **1310,** and the second region **1124** may be disposed in the first groove **1240.** An upper surface of the second region **1124** may be in contact with a bottom surface of the first groove **1240.** The cross-sectional area of the second region **1124** may be larger than the cross-sectional area of the first region **1122.**

A lower end of the protrusion **1120,** that is, an end surface of the second region **1124,** that is, a lower surface, may be a curved surface having a predetermined curvature. The second region **1124** may have a donut shape.

A second groove **1126** may be formed on a lower surface of the protrusion **1120** in a shape being recessed more upwardly than other regions. A bottom surface of the second groove **1126,** that is, an upper end of the second groove **1126** may be disposed at a lower side than a lower surface of the printed circuit board **1300.**

The protrusion **1120** may be a region being formed when the housing **1100** and the cover **1200** are fused by heat or laser fusion. In the protrusion **1120,** the second region **1124** may be a region fused by heat or laser.

Hereinafter, a process of assembling the housing **1100,** the cover **1200,** and the printed circuit board **1300** will be described.

The housing **1100,** the cover **1200,** and the printed circuit board **1300** may be coupled to one another by heat or laser fusion.

Before thermal fusion, the housing **1100,** the cover **1200,** and the printed circuit board **1300** may be assembled as shown in FIG. 21. FIG. 21 illustrates the housing **1100,** the cover **1200,** and the printed circuit board **1300** by interchanging the up and down directions, and for convenience of description, the region being protruded downward from a lower surface of the first protruded portion **1130** of the housing **1100** before the fusion process is referred to as a first coupling portion **1170,** and a region being protruded downward from a lower surface of the cover **1200** before the fusion process is referred to as a second coupling portion **1270** and will be described. To form the second groove **1126,** a groove **1172** is formed inside the first coupling portion **1170,** and the second coupling portion **1270** moves downward from the bottom surface of the first groove **1240** so that a hole to which the first coupling portion **1170** is coupled may be formed inside.

First, as illustrated in FIG. 17, the second hole **1310** of the printed circuit board **1300** is coupled to the first coupling portion **1170** of the housing **1100.** Accordingly, the printed circuit board **1300** may be primarily fixed in a state of being in contact with a lower surface of the first protruded portion **1130.**

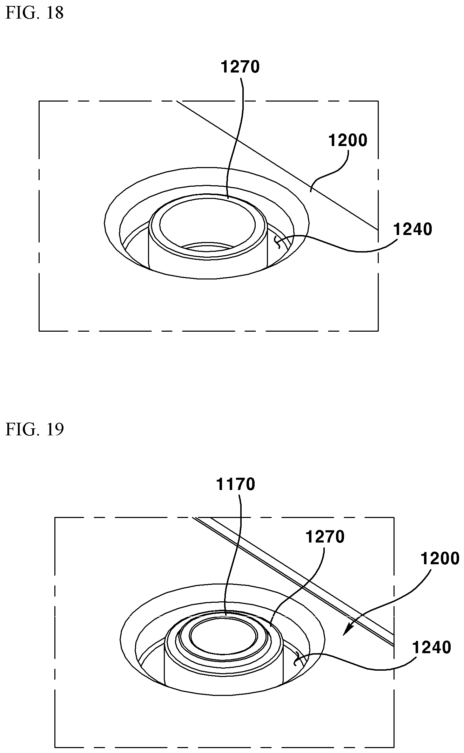

Next, as illustrated in FIGS. 18 and 19, the first coupling portion **1170** coupled to the printed circuit board **1300** is coupled to the inside of the second coupling portion **1270.** At this time, a lower end of the first coupling portion **1170** may be protruded lower than a lower end of the second coupling portion **1270.** The coupled state illustrated as a cross-sectional view in FIG. 16(a), FIG. 19, is the same as in FIG. 21.

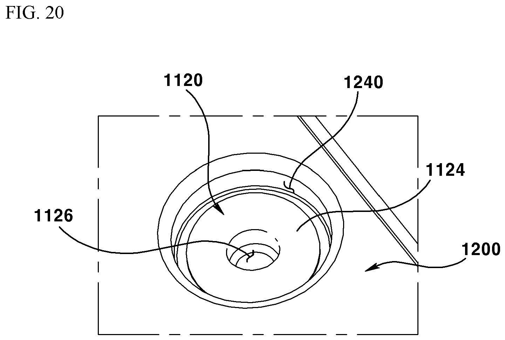

Next, as shown in FIG. 20, the first coupling portion **1170** and the second coupling portion **1270** are fused using heat or laser. Accordingly, the protrusion **1120** may be formed as shown in FIG. 13 and FIG. 16(b). That is, the protrusion **1120** may be formed by curing a fusion material of the first coupling portion **1170** and the second coupling portion **1270.**

According to the above structure, since the housing **1100,** the cover **1200,** and the printed circuit board **1300** can be coupled together by a fusion process, there are advantages in that the number of components for coupling is reduced, and the fastening process can be accomplished more simply.

In addition, as shown in FIG. 22, since the occurrence of a gap between the housing **1100** and the cover **1200** is prevented by the fusion process, the coupling force between the housing **1100** and the cover **1200** may be accomplished more firmly. In other words, since a gap is prevented from being generated between an outer circumferential surface of the first region **1122** inside the protrusion **1120** and the inner circumferential surface of the first hole **1230,** the coupled state between the housing **1100** and the cover **1200** can be maintained more firmly.

As illustrated in FIG. 21, for a strong fusion force between the housing **1100** and the cover **1200** through the fusion process, the diameter **A** of the first coupling portion **1170** before the fusion process may be smaller than the diameter of the second hole **1310** in the printed circuit board **1300.** Accordingly, a gap **H** may be formed between an outer surface of the first coupling portion **1170** and an inner surface of the second hole **1310** in the printed circuit board **1300.**

In addition, the diameter **A** of the first coupling portion **1170** before the fusion process may be smaller than the diameter of the hole in the second coupling portion **1270.** Accordingly, a gap **D** may be formed between an outer surface of the first coupling portion **1170** and an inner surface of the hole in the second coupling portion **1270.**

In addition, the gap **D** between the outer circumferential surface of the first coupling portion **1170** and the inner surface of the hole of the second coupling portion **1270** before the fusion process may be smaller than the gap **H** between the outer circumferential surface of the first coupling portion **1170** and the inner surface of the second hole **1310** before the fusion process.

In addition, the gap **E** between the lower end of the first coupling portion **1170** and the lower end of the second coupling portion **1270** before the fusion process may be smaller than 1/5 of the height **F** of the second coupling portion **1270** being protruded from the bottom surface of the first groove **1240.** In addition, the diameter **B** of the groove **1172** in the first coupling portion **1170** before the fusion process may be larger than 1/2 of the diameter **A** of the first coupling portion **1170.**

In the above description, it is described that all the components constituting the embodiments of the present invention are combined or operated in one, but the present invention is not necessarily limited to these embodiments. In other words, within the scope of the present invention, all of the components may be selectively operated in combination with one or more. In addition, the terms "comprise", "include" or "having" described above mean that the corresponding component may be inherent unless specifically stated otherwise, and thus it should be construed that it does not exclude other components, but further include other components instead. All terms, including technical and scientific terms, have the same meaning as commonly understood by one of ordinary skill in the art unless otherwise defined. Terms used generally, such as terms defined in a dictionary, should be interpreted to coincide with the contextual meaning of the related art, and shall not be interpreted in an ideal or excessively formal sense unless explicitly defined in the present invention.

The above description is merely illustrative of the technical idea of the present invention, and those skilled in the art to which the present invention pertains may make various modifications and changes without departing from the essential characteristics of the present invention. Therefore, the embodiments disclosed in the present invention are not intended to limit the technical idea of the present invention but to describe the present invention, and the scope of the technical idea of the present invention is not limited by these embodiments. The protection scope of the present invention should be interpreted by the following claims, and all technical ideas within the equivalent scope should be interpreted as being included in the scope of the present invention.

## Claims

1. An electric equipment comprising:
a housing;
a printed circuit board being disposed inside the housing and including a first hole; and
a cover being coupled to an upper surface of the housing and including a second hole,
wherein the housing includes:
a first region being disposed to penetrate through the first hole;
a second region being disposed at an upper portion of the first region and being disposed to penetrate through the second hole; and
a third region being disposed at an upper portion of the second region and being disposed on an upper surface of the cover.

2. The electric equipment according to claim 1,
wherein the cover is more recessed downwardly from an upper surface than the other regions and includes a coupling groove being disposed with the third region inside thereof.

3. The electric equipment according to claim 2,
wherein a lower surface of the third region is in contact with a bottom surface of the coupling groove.

4. The electric equipment according to claim 1,
wherein a lower surface of the housing includes a protruded portion being protruded downward, and a lower surface of the protruded portion is in contact with an upper surface of the printed circuit board.

5. The electric equipment according to claim 4,
wherein an accommodating groove being recessed more upward than other regions is disposed on a lower surface of the protruded portion, and
wherein an upper surface of the first region is in contact with a bottom surface of the accommodating groove.

6. The electric equipment according to claim 5,
wherein the cross-sectional area of the first region is larger than the cross-sectional area of the second region.

7. The electric equipment according to any one among claim 1 to 5,
wherein a groove being formed along an edge of the second region is disposed on an upper surface of the first region.

8. A method for manufacturing An electric equipment comprising: a housing including a first coupling portion being protruded upward from an upper surface; a printed circuit board being disposed at an upper portion of the housing and including a first hole; and a cover comprising a second coupling portion being disposed at an upper portion of the printed circuit board, having a coupling groove being formed on an upper surface, and being protruded upward from a bottom surface of the coupling groove, and a second hole penetrating a lower surface from the bottom surface of the coupling groove,
wherein the method comprises the steps of:
(a) penetrating through the first hole and the second hole by the first coupling portion; and
(b) forming a protrusion inside the coupling groove by fusing the first coupling portion or the second coupling portion with heat or laser.

9. The electric equipment according to claim 8,
wherein the height of the first coupling portion being protruded from the bottom surface of the coupling groove is the same as the height of the second coupling portion being protruded from the bottom surface of the coupling groove.

10. The electric equipment according to claim 8,
wherein the height of the first coupling portion being protruded from a bottom surface of the coupling groove is greater than the height of the second coupling portion being protruded from a bottom surface of the coupling groove.

11. The electric equipment according to claim 8,
wherein the height of the first coupling portion being protruded from the bottom surface of the coupling groove is greater than the height of the second coupling portion being protruded from the bottom surface of the coupling groove.
